# EUROPÄISCHE PATENTANMELDUNG

(11) **EP 1 906 722 A2**
(43) Veröffentlichungstag der Anmeldung: **02.04.2008**
(21) Anmeldenummer: 07115261.5
(22) Anmeldetag: 30.08.2007
(51) Int. Cl.: H05K 13/04

(54) **Positioniersystem mit magnetisch vorgespannter Linearachse**

(30) Priorität: 26.09.2006 DE 102006045301
(71) Anmelder: SIEMENS AKTIENGESELLSCHAFT, 80333 München (DE)
(72) Erfinder: Krupke, Susan, 81475, München (DE); Mehdianpour, Mohammad, 81829, München (DE)

(57) **Zusammenfassung**

Diese Anmeldung beschreibt ein Positioniersystem zum Bewegen eines Bestückkopfes (207) eines Bestückautomaten entlang einer x-Achse zum Zwecke der Bestückung von Bauelementeträgern mit elektronischen Bauelementen (221). Das Positioniersystem weist auf einen Trägerarm (204), eine Linearführung, welche an dem Trägerarm (204) angebracht ist und welche entlang einer x-Achse verläuft, ein Halteelement (206), welches an der Linearführung entlang der x-Achse verschiebbar gelagert ist und welches derart ausgebildet ist, dass der Bestückkopf (207) an dem Halteelement (206) anbringbar ist, und einen Linearmotor (260), welcher mit dem Trägerarm (104, 204) und dem Halteelement (206) derart gekoppelt ist, dass bei einer entsprechenden Ansteuerung des Linearmotors (260) das Halteelement (206) entlang der x-Achse verfahrbar ist. Zumindest ein Abschnitt des Halteelements (206), an welchem Abschnitt der Bestückkopf (207) anbringbar ist, ist relativ zu dem Trägerarm (204) auf einer ersten Seite angeordnet ist. Der Linearmotor (260) ist relativ zu dem Trägerarm (204) auf einer zweiten Seite angeordnet ist, die unterschiedlich zu der ersten Seite ist.

## Beschreibung

Die vorliegende Erfindung betrifft ein Positioniersystem zum linearen Bewegen eines Bestückkopfes eines Bestückautomaten entlang einer x-Achse zum Zwecke der Bestückung von Bauelementeträgern mit elektronischen Bauelementen.

Die vorliegende Erfindung betrifft ferner ein Flächen-Positioniersystem zum zweidimensionalen Bewegen eines Bestückkopfes eines Bestückautomaten parallel zu einer durch eine x-Achse und durch eine y-Achse definierten Bestückebene zum Zwecke der Bestückung von Bauelementeträgern mit elektronischen Bauelementen.

Außerdem betrifft die vorliegende Erfindung eine Vorrichtung zum automatischen Bestücken von Bauelementeträgern mit elektronischen Bauelementen, wobei zum Bewegen eines Bestückkopfes das genannte Positioniersystem oder das genannte Flächen-Positioniersystem verwendet wird.

Aufgrund der zunehmenden Miniaturisierung von elektronischen Baugruppen werden an die Bestückgenauigkeit von modernen Bestückvorrichtungen bzw. Bestückautomaten hohe Anforderungen gestellt. Mittels Bestückautomaten werden elektronische Bauelemente auf einen elektronischen Bauelementeträger wie beispielsweise eine Leiterplatte, ein Substrat oder einen sonstigen Schaltungsträger platziert. Dabei wird typischerweise ein positionierbarer Bestückkopf verwendet, mit dem Bauelemente von einer Abholposition einer Bauelement-Zuführeinrichtung hin zu einer Bestückposition transportiert und an vorgegebenen Einbauplätzen auf den Bauelementeträger aufsetzt werden können. Für eine hohe Bestückgenauigkeit ist demzufolge ein Positioniersystem erforderlich, mit dem ein Bestückkopf präzise positioniert werden kann.

Aus der DE 103 02 103 A1 ist eine Montageeinrichtung für elektronische Bauelemente bekannt, bei der, wie in Figur 3B dargestellt, eine Kopfmontagestütze 7a mittels einer Doppel-Linearführung an einem Balken 7f verschiebbar gelagert ist. Die Doppel-Linearführung weist zwei Gleitführungen 7b auf. Die Kopfmontagestütze 7a ist mittels eines Spindelantriebs 7d relativ zu dem Balken 7f verschiebbar.

Aus der DE 103 09 880 A1 ist eine Trägerplatte für ein Spulenteil eines Linearmotors bekannt. Die Trägerplatte ermöglicht eine Übertragung von Magnetkräften, die von magnetischen Antriebsteilen erzeugt werden, auf seitliche Linearführungen. Die Trägerplatte ist aus zwei beispielsweise miteinander verklebten Materialschichten gebildet, die unterschiedliche Wärmeausdehnungskoeffizienten aufweisen. Eine den Antriebsteilen abgewandte Oberschicht weist im Vergleich zu einer Unterschicht eine erheblich höhere Wärmeausdehnung auf. Verbindungszapfen übertragen einen Teil der Betriebswärme von den Antriebsteilen zur Oberschicht. Bei einem Wärmeeintrag dehnt sich diese entsprechend stärker aus als die Unterschicht und wirkt so der von den Magnetkräften bewirkten Durchbiegung entgegen.

Aus der EP 1 600 046 B1 ist eine Bestückvorrichtung bekannt, bei der mittels eines in einer Arbeitsebene verfahrbaren Bestückkopfes Bauelemente auf ein Substrat platziert werden können. Der Bestückkopf ist mittels eines Positioniersystems verfahrbar, welches einen in einer stationären Längsführung verfahrbaren Positionierarm und eine zu Längsführung quer stehende lineare Querführung aufweist. Der Bestückkopf ist mittels eines Linearmotors entlang der Querführung verfahrbar. Ein Stator des Linearmotors wird durch eine am Träger befestigte Magnetschiene gebildet. Ein mobiles Spulenteil des Linearmotors ist dem Bestückkopf fest zugeordnet ist. Eine die Magnetschiene tragende Seitenwand des Trägers weist Verstärkungselemente auf, die zum unmittelbaren Abfangen von zwischen der Magnetschiene und dem Spulenteil wirkenden Magnetkräften vorgesehen sind.

Aus der WO 2005/112232 A1 ist eine Vorrichtung zum Anbinden eines Linearmotorläufers an eine Linearführung bekannt, welche Vorrichtung insbesondere in einer Bestückvorrichtung zum Bestücken von Substraten mit Bauelementen verwendet wird. Die Vorrichtung umfasst einen Linearmotorläufer und ein mobiles Montageteil, an dem mindestens ein Führungselement vorgesehen ist, mit welchem das mobile Montageteil mit der Linearführung in Eingriff gebracht werden kann. Ferner ist mindestens ein Distanzelement vorgesehen, über das der Linearmotorläufer mit dem mobilen Montageteil verbunden ist, sodass zwischen dem Linearmotorläufer und dem mobilen Montageteil ein Zwischenraum entsteht, in den sich der Linearmotorläufer verformen kann. Thermische Spannungen oder Verformungen aufgrund magnetischer Kräfte zwischen dem Linearmotorläufer und einem Stator des Linearmotors werden dadurch nicht auf die Lager der Linearführung übertragen.

Der Erfindung liegt die Aufgabe zugrunde, ein Positioniersystem zu schaffen, welches eine im Vergleich zu bekannten einen Linearmotor aufweisenden Positioniersystemen eine verbesserte, d.h. größer Positioniergenauigkeit für einen Bestückkopf ermöglicht.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Positioniersystem zum Bewegen eines Bestückkopfes eines Bestückautomaten entlang einer x-Achse zum Zwecke der Bestückung von Bauelementeträgern mit elektronischen Bauelementen beschrieben. Das Positioniersystem weist auf (a) einen Trägerarm, (b) eine Linearführung, welche an dem Trägerarm angebracht ist und welche entlang einer x-Achse verläuft, (c) ein Halteelement, welches an der Linearführung entlang der x-Achse verschiebbar gelagert ist und welches derart ausgebildet ist, dass der Bestückkopf an dem Halteelement anbringbar ist, und (d) einen Linearmotor, welcher mit dem Trägerarm und dem Halteelement derart gekoppelt ist, dass bei einer entsprechenden Ansteuerung des Linearmotors das Halteelement entlang der x-Achse verfahrbar ist. Erfindungsgemäß ist zum einen zumindest ein Abschnitt des Halteelements, an welchem Abschnitt der Bestückkopf anbringbar ist, relativ zu dem Trägerarm auf einer ersten Seite angeordnet ist und zum anderen der Linearmotor relativ zu dem Trägerarm auf einer zweiten Seite angeordnet ist, die unterschiedlich zu der ersten Seite ist.

Dem beschriebenen Positioniersystem liegt die Erkenntnis zugrunde, dass der Linearmotor nicht in einem Zwischenraum angeordnet wird, der sich zwischen dem Trägerarm und dem an dem Trägerelement angebrachten Bestückkopf erstreckt. Da in der Regel der Bestückkopf seitlich an dem Trägerelement angebracht ist, bedeutet dies, dass der Linearmotor relativ zu dem Trägerarm vorzugsweise entweder oberhalb, unterhalb oder auf der dem Bestückkopf bzw. der Trägerelement abgewandten Seite angebracht ist. Auf diese Weise ist der Linearmotor von dem Trägerelement bzw. dem Bestückkopf beabstandet, so dass die thermische Kopplung zwischen der Wärmequelle Linearmotor und dem Bestückkopf geringer ist und somit eine verbesserte Wärmeabfuhr realisiert ist.

Sofern der Linearmotor oberhalb oder unterhalb des Trägerarms angeordnet ist führt ein von dem Linearmotor erzeugter Wärmestrom zu einem vorzugsweise lediglich zu einem Verzug des Trägerelements in vertikaler z-Richtung. Dies ist vorteilhaft, da ein Verzug lediglich in z-Richtung bei einem Bestückvorgang lediglich einen sehr geringen Einfluss auf die erreichbare Bestückgenauigkeit hat. Die Bestückgenauigkeit ist nämlich durch die Abweichung der realen Ist-Bestückposition von einer Soll-Bestückposition in einer Bestückebene bestimmt, die senkrecht zur z-Achse orientiert ist.

Es wir darauf hingewiesen, dass der Ausdruck "auf einer ersten Seite" bzw. der Ausdruck "auf einer zweiten Seite" nicht bedeutet, dass der Halteelement-Abschnitt bzw. der Linearmotor direkt an dem Trägerarm anliegen muss. Vielmehr wird durch diese Ausdrücke festgelegt, dass aus Sicht des Trägerarms der Halteelement-Abschnitt und der Linearmotor in unterschiedlichen Raumrichtungen angeordnet sind.

Der Bestückkopf ist in bekannter Weise zum Aufnehmen, Transportieren und Aufsetzen von Bauelementen eingerichtet. Der Bestückkopf kann ein so genannter Einfachbestückkopf mit einer einzigen Bauelement-Haltevorrichtung oder auch ein Mehrfachbestückkopf mit mehreren Bauelement-Haltevorrichtungen sein. Bei einem Mehrfach-Bestückkopf kann bei Anwendung des so genannten Collect & Place Prinzips zunächst eine Mehrzahl von Bauelementen von einer oder von mehreren Bauelement-Zuführeinrichtungen abgeholt und gemeinsam in die Nähe von den Bauelementen zugeordneten Aufsetzpositionen oberhalb eines zu bestückenden Bauelementeträgers transportiert werden. Dort werden sie dann an den vorgegebenen Einbaupositionen des Bauelementeträgers sequentiell bestückt.

Die Verwendung eines Linearmotors ermöglicht auf vorteilhafte Weise direkt eine translatorische Bewegung des Halteelements. Eine Umwandlung von einer Drehbewegung in eine translatorische Verschiebebewegung wie beispielsweise bei einem Spindelantrieb ist demzufolge nicht erforderlich. Linearmotoren haben zudem den Vorteil, dass präzise Positionierbewegungen auch bei hohen Beschleunigen bis zu einem sechsfachen der Erdbeschleunigung realisierbar sind.

Gemäß einem Ausführungsbeispiel der vorliegenden Erfindung nach Anspruch 2 ist der Linearmotor zumindest entlang einer zu der x-Achse senkrechten y-Achse von dem Halteelement beabstandet, so dass zwischen Halteelement und Linearmotor ein erster Zwischenraum vorhanden ist.

Durch die bewusste Beabstandung des Linearmotors von dem Halteelement kann der Wärmeeintrag von dem Linearmotor auf einen an dem Trägerelement angebrachten Bestückkopf zusätzlich reduziert werden. Damit ist der Bestückkopf von der Betriebswärme des Linearmotors, die abhängig von den jeweiligen Betriebsbedingungen des Linearmotors unterschiedlich stark sein kann, weitgehend entkoppelt. Dadurch kann der Bestückkopf auch bei unterschiedlichen Betriebsbedingungen des Positioniersystems bei einer vergleichsweise konstanten Betriebstemperatur arbeiten, so dass eine verbesserte, d.h. höhere Bestückgenauigkeit erzielbar ist. Selbstverständlich kann der von dem Linearmotor erzeugte Wärmeeintrag auf den Bestückkopf zusätzlich durch eine Kühlung oder eine thermische Isolierung des Linearmotors reduziert werden.

Durch die thermische Entkopplung zwischen Linearmotor und Halteelement ist auch die am Trägerarm angebrachte Linearführung einer geringeren Abwärme ausgesetzt, so dass innerhalb der Linearführung geringere thermischen Spannung auftreten und somit zudem eine verbesserte Positioniergenauigkeit realisiert werden kann.

Gemäß einem Ausführungsbeispiel der vorliegenden Erfindung nach Anspruch 3 ist der Trägerarm entlang der y-Achse von dem Halteelement beabstandet, so dass zwischen Halteelement und Trägerarm ein zweiter Zwischenraum vorhanden ist. Auf diese Weise kann eine zusätzliche thermische Entkopplung zwischen Halteelement bzw. einem daran angebrachten Bestückkopf auf der einen Seite und dem Trägerarm bzw. dem mit dem Trägerarm gekoppelten Linearmotor auf der anderen Seite erreicht werden. Damit wird die Bestückgenauigkeit des Bestückkopfes auch von einer ggf. vorhandenen Erwärmung des Trägerarms weitgehend unabhängig.

Die Existenz des zweiten Zwischenraums hat zudem den Vorteil, dass zwischen Halteelement und Trägerarm ein Sicherheitsabstand besteht, so dass auch bei gegebenenfalls auftretenden thermischen Verzügen von Halteelement und/oder Trägerarm kein direkter mechanischer Kontakt und damit keine zusätzliche Reibung zwischen dem Halteelement und dem Trägerarm entsteht.

Gemäß einem weiteren Ausführungsbeispiel der Erfindung nach Anspruch 4 weist der Linearmotor einen Stator, welcher an dem Trägerarm angebracht ist, und einen Läufer auf, welcher an dem Halteelement angebracht ist.

Der Stator weist dabei typischerweise mehrere an dem Trägerarm alternierend angeordnete Magnete auf. Die Magnete können Elektromagnete oder Permanentmagnete sein. Es kann auch eine Mischung von Elektro- und Permanentmagnete verwendet werden. Die Verwendung von Permanentmagneten hat den Vorteil, dass der Stator als elektrisch passives Element realisiert werden kann, so dass für den Stator keine elektrische Versorgungsleitungen erforderlich sind, um das Positioniersystem zu betreiben. Die Verwendung von Permanentmagneten hat zudem den Vorteil, dass zur Erzeugung eines Stator-Magnetfeldes keine elektrischen Ströme benötigt werden, so dass der durch den Betrieb des Linearmotors erzeugte Wärmeeintrag vergleichsweise gering ist.

Der Läufer weist typischerweise zumindest eine elektrische Magnetfelderzeigungseinheit, insbesondere eine Magnetspule auf. Der Läufer ist damit die elektrisch aktive Komponente des Linearmotors.

Gemäß einem weiteren Ausführungsbeispiel der Erfindung nach Anspruch 5 weist die Linearführung eine erste Lagerung auf. Die erste Lagerung umfasst eine Führungsschiene und zumindest einen Linearführungswagen, welcher derart an der Führungsschiene angebracht ist, dass die erste Lagerung quer zur x-Achse ein Festlager und parallel zur x-Achse ein Loslager darstellt.

Bevorzugt sind zwei Linearführungswägen vorgesehen, so dass auf einfache Weise eine geschlossene erste Lagerung realisiert werden kann, welche entlang der y-Achse bzw. entlang einer zu der x-Achse und zu der y-Achse senkrechten z-Achse ein Festlager und entlang der x-Achse ein Loslager darstellt. Die erste Lagerung stellt somit bereits eine vollständig funktionsfähige Linearführung dar, weil innerhalb einer zu der x-Achse senkrecht orientierten Ebene weder eine Verschiebung des Halteelements noch eine Verkippung des Halteelements relativ zu dem Trägerarm möglich ist. Allerdings werden insbesondere bei einem hochdynamischen Betrieb des Portalsystems mit großen Beschleunigungen und Verzögerungen kurzeitige Verzüge auftreten, welche die Bestückgenauigkeit negativ beeinflussen können. Dies gilt auch für den Betrieb eines an das Halteelement angebrachten Bestückkopfes, bei dem Bauelemente durch gezielte Bewegungen von Bauelement-Haltevorrichtungen wie beispielsweise Saugpipetten entlang einer zu der x-Achse und zu der y-Achse senkrechten z-Achse aufgenommen und abgesetzt werden.

Gemäß einem weiteren Ausführungsbeispiel der Erfindung nach Anspruch 6 weist die Linearführung eine zweite Lagerung auf, die ein Loslager darstellt und die in Bezug auf die erste Lagerung derart angeordnet ist, dass eine zwischen Stator und Läufer erzeugt magnetische Anziehungskraft des Linearmotors eine Fixierung des Loslagers zumindest entlang der y-Achse bewirkt.

Die Fixierung des Loslagers entlang der y-Achse ist dabei derart zu verstehen, dass die Magnetkraft des Linearmotors ein Drehmoment parallel zu der x-Achse bewirkt. Dieses Drehmoment würde in Abwesenheit der zweiten Lagerung dazu führen, dass sich das Halteelement um die x-Achse verkippen würde, so dass das Halteelement fest gegen den Trägerarm gedrückt werden würde. Dieses durch die Magnetkraft des Linearmotors erzeugte Dreh- bzw. Kippmoment führt jedoch dazu, dass in der yz-Ebene die relative Lage zwischen dem Halteelement und dem Trägerarm genau festgelegt ist, da die zweite Lagerung dadurch belastet und somit sowohl die Position als auch die Orientierung des Halteelements relativ zu dem Trägerarm in der yz-Ebene genau definiert wird.

Selbstverständlich bleibt die Verschiebbarkeit des Halteelements relativ zu dem Trägerarm entlang der x-Achse auch bei der Verwendung einer Kombination von zwei Lagerungen erhalten.

Die obere Lagerung kann auf vielfältige Weise beispielsweise mittels eines Gleitlagers realisiert werden. Die beteiligten Materialien sollten dabei derart gewählt werden, dass eine geringe Gleitreibung zwischen dem Halteelement und dem Trägerarm bzw. einem mit dem Trägerarm verbundenen Laufflächenelement gewährleistet ist.

Gemäß einem weiteren Ausführungsbeispiel der Erfindung nach Anspruch 7 weist die zweite Lagerung zumindest eine Rolle weist, welche an einer Abrollfläche des Trägerarms oder des Halteelements abrollbar ist. Dies hat den Vorteil, dass die zweite Lagerung auf einfache Weise realisiert werden kann, wobei bei einer entsprechend reibungsarmen Lagerung der Rolle in einer Drehachse ein geringer Reibungswiderstand des Positioniersystems erreicht werden kann.

Bevorzugt ist die Rolle an dem Halteelement drehbar gelagert, so dass an dem Trägerarm lediglich eine Lauffläche vorgesehen sein muss, an der sich die Rolle abstützt und entlang der sich die Rolle abrollt, wenn das Halteelement an dem Trägerarm entlang der x-Achse verschoben wird. Die Lauffläche kann dabei direkt an dem Trägerarm ausgebildet sein. Alternativ kann die Lauffläche beispielsweise durch ein präzise gefertigtes Profilelement bereitgestellt werden, welches sich entlang der x-Achse an dem Trägerarm erstreckt. Im einfachsten Fall ist das Profilelement eine Leiste, die im Querschnitt einen einfachen Winkel darstellt.

Um eine hohe Kippstabilität des Halteelements gegenüber einer ungewollten Verkippung in der yz-Ebene zu gewährleisten, können entlang der x-Achse versetzt mehrere Rollen vorgesehen sein. Eine hohe Kippstabilität führt insbesondere bei einem hochdynamischen Betrieb des beschriebenen Positioniersystems zu einer Erhöhung der Bestückgenauigkeit.

Das Positioniersystem kann so ausgelegt werden, dass die Rolle bzw. die Rollen im wesentlichen lediglich der Aufnahme von dynamischen Lasten dienen und nicht mit der gesamten Magnetkraft des Linearmotors beaufschlagt werden. Die Magnetkraft des Linearmotors kann insbesondere von der ersten Lagerung aufgenommen werden. Die Vorspannung der Rollen kann beispielsweise durch die mechanische Steifigkeit des Halteelements bzw. durch die Verformung des Halteelements infolge der Magnetkraft des Linearmotors eingestellt werden. Hierbei kann mit einer verringerten Steifigkeit des Halteelements oder mit einer gezielten lokalen Elastizität des Halteelements eine höhere Vorspannung der Rollen erreicht werden. Selbstverständlich ist bei höheren elastischen Verformungen sicherzustellen, dass sich der Magnetspalt des Linearmotors nicht so weit reduziert, dass ein unterer Toleranzwert für den Magnetspalt unterschritten wird.

Des Weiteren kann die Vorspannung der Rollen durch die Anordnung des Linearmotors gewährleistet werden. Durch die Vergrößerung des Winkels zwischen Rollenachse und Linearmotoranzugsrichtung von 0° auf bis zu 90° kann die Rollenvorspannung erhöht werden.

Die Einstellbarkeit der Rollenvorspannung kann ggf. auch während des Betriebes durch eine dynamische Ansteuerung eines variablen Versteifungselementes angepasst werden. Unabhängig von einer ggf. vorhandenen dynamischen Anpassung hat die Einstellbarkeit der Rollenvorspannung den Vorteil, dass für die Rollen optimale Laufbedingungen gewährleistet werden können. Auch bei hochdynamischen Bewegungen erfolgt dann kein Abheben der Rollen von der vorgesehenen Lauffläche.

Durch die beschriebene Kombination aus der ersten und der zweiten Lagerung können Beschleunigungen sowohl entlang der x-Achse als auch entlang der y-Achse optimal aufgenommen werden. Daraus ergeben sich insgesamt positive Systemeigenschaften des beschriebenen Positioniersystems wie beispielsweise hohe Schwingungs-Eigenfrequenzen und eine hohe Dämpfung, die wiederum beim ungewollten Auftreten von Schwingungen zu besonders kurzen Ausschwingzeiten des Positioniersystems führt.

Gemäß einem weiteren Ausführungsbeispiel der Erfindung nach Anspruch 8 ist die erste Lagerung unterhalb der zweiten Lagerung angeordnet. Dies hat den Vorteil, dass sich diejenige Lagerung, die quer zur x-Achse ein Festlager darstellt, näher an einer Bestückebene befindet als diejenige Lagerung, die in allen Richtungen ein Loslager darstellt. Damit befindet sich das Festlager näher an dem Aufsetzort für Bauelemente, die von einem an dem Halteelement angebrachten Bestückkopf auf einen in der Bestückebene befindlichen Bauelementeträger aufgesetzt werden. Im Vergleich zu dem umgekehrten Fall, bei dem das Festlager weiter von der Bestückebene entfernt ist als das Loslager, führt diese insbesondere bei einem hochdynamischen Betrieb des Positioniersystems zu einer höheren Bestückgenauigkeit.

Gemäß einem weiteren Ausführungsbeispiel der Erfindung nach Anspruch 9 ist das Halteelement eine Kopfhalteplatte. Dies bedeutet, dass zumindest eine dem Trägerarm abgewandte Seite des Halteelements eine weitgehend plane Ebene darstellt, an welcher der Bestückkopf unter Ausnutzung einer vergleichsweise großen Auflagefläche sicher befestigt werden kann.

Mit dem nebengeordneten Patentanspruch 10 wird ein Flächen-Positioniersystem zum Bewegen eines Bestückkopfes eines Bestückautomaten parallel zu einer durch eine x-Achse und eine y-Achse definierten Bestückebene zum Zwecke der Bestückung von Bauelementeträgern mit elektronischen Bauelementen beschrieben. Das Flächen-Positioniersystem weist auf (a) eine stationäre Linearführung, welche entlang einer y-Richtung verläuft, und (b) ein Positioniersystem gemäß einem der oben beschriebenen Ausführungsbeispiele.

Das oben beschriebene lineare Positioniersystem kann somit in vorteilhafter Weise auch für ein zweidimensionales Flächenpositioniersystem verwendet werden. In diesem Zusammenhang wird darauf hingewiesen, dass die im Zusammenhang mit dem Positioniersystem beschriebene Linearführung und die für das Flächenpositioniersystem erforderliche stationäre Linearführung unterschiedliche Führungen darstellen.

Mit dem nebengeordneten Patentanspruch 11 wird eine Vorrichtung zum automatischen Bestücken von Bauelementeträgern mit elektronischen Bauelementen beschrieben. Die Vorrichtung weist ein oben beschriebenes lineares Positioniersystem und/oder ein ebenfalls oben beschriebenes Flächen-Positioniersystem auf.

Die Vorrichtung zum automatischen Bestücken, welche auch als Bestückautomat bezeichnet werden kann, weist typischerweise einen Bestückkopf auf, mit dem elektronische Bauelemente von einer Abholposition abgeholt, zu einer Bestückposition oberhalb eines Bauelementeträgers transportiert und an vorgegebenen Stellen auf den Bauelementeträger aufgesetzt werden. Dabei werden die Bauelemente jeweils in einer genau festgelegten Position auf dem Bauelementeträger aufgesetzt. Diese Bestückposition ist durch entsprechende Bauelement-Anschlussflächen für eine elektrische Kontaktierung der Bauelemente bestimmt.

Gemäß einem Ausführungsbeispiel der vorliegenden Erfindung nach Anspruch 12 weist die Vorrichtung zusätzlich eine Bauelement-Zuführvorrichtung zum sequentiellen Bereitstellen von Bauelementen an zumindest einer Abholposition auf, von der die Bauelemente von dem Bestückkopf aufgenommen werden können.

Das verwendete Positioniersystem bzw. das verwendete Flächen-Positioniersystem ist dabei derart dimensioniert, dass der Bestückkopf nicht nur oberhalb des eigentlichen Bestückbereiches, sondern auch oberhalb der Bauelement-Zuführvorrichtung positioniert werden kann, so dass die bereitgestellten Bauelemente nicht nur zügig bestückt, sondern auch zügig abgeholt werden können. Infolge der hohen mechanischen Präzision, die mit den oben beschriebenen Positioniersystemen erreicht werden kann, ist somit nicht nur eine hochgenaue Bestückung, sondern auch eine hochgenaue Abholung der bereitgestellten Bauelemente möglich.

Gemäß einem weiteren Ausführungsbeispiel der Erfindung nach Anspruch 13 weist die Vorrichtung zusätzlich eine Kamera auf, welche relativ zu dem Halteelement in einer festen räumlichen Position angeordnet ist und welche zur Erfassung eines in einen Bestückbereich eingebrachten Bauelementeträgers eingerichtet ist.

Die Kamera kann dabei einzelne an dem Bauelementeträger ausgebildete Markierungen erfassen, anhand derer mittels einer der Kamera nachgeschalteten Auswerteeinheit die exakte Position des in den Bestückbereich des Bestückautomaten eingebrachten Bauelementeträgers bestimmt werden kann. Eine genaue Kenntnis der Position des Bauelementeträgers ist insbesondere im Hinblick auf die zunehmende Miniaturisierung von elektronischen Baugruppen erforderlich, damit die Bauelemente auch tatsächlich an der richtigen Stelle auf den Bauelementeträger aufgesetzt werden.

Da das Gesichtsfeld der verwendeten Kamera, welche auch als Leiterplattenkamera bezeichnet wird, typischerweise deutlich kleiner ist als ein zu bestückender Bauelementeträger, können mit einer Kameraaufnahme nicht gleichzeitig alle an dem Bauelementeträger vorhandenen Markierungen erfasst werden. Aus diesem Grund ist nach dem Einbringen eines zu bestückenden Bauelementeträgers in den Bestückbereich ein gezieltes Verfahren der Kamera erforderlich, um sequentiell zumindest einige der Markierungen zu erfassen und um somit die exakte räumliche Lage des zu bestückenden Bauelementeträgers in dem Bestückbereich zu bestimmen. Durch das Anbringen der Kamera an das Halteelement, kann somit auf vorteilhafte Weise auf die Bereitstellung eines separaten Positioniersystems für die Kamera verzichtet werden.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine perspektivische Darstellung einer Bestückvorrichtung, welche ein Flächenpositioniersystem gemäß einem Ausführungsbeispiel der Erfindung aufweist,
- Figur 2: eine Querschnittsansicht eines linearen Positioniersystems gemäß einem ersten Ausführungsbeispiel, bei dem der Linearmotor von einem Halteelement für einen Bestückautomaten beabstandet ist und bei dem zwei voneinander beabstandete Lagerungen vorgesehen sind, wobei ein Lager ein Festlager und das andere Lager ein durch eine Magnetkraft des Linearmotors belastetes Loslager ist, und
- Figur 3: eine Querschnittsansicht eines linearen Positioniersystems gemäß einem zweiten Ausführungsbeispiel, bei dem die Auflagefläche des Loslagers auf die räumliche Anordnung des Festlagers ausgerichtet ist.

An dieser Stelle bleibt anzumerken, dass sich in der Zeichnung die Bezugszeichen von gleichen oder von einander entsprechenden Komponenten lediglich in ihrer ersten Ziffer unterscheiden.

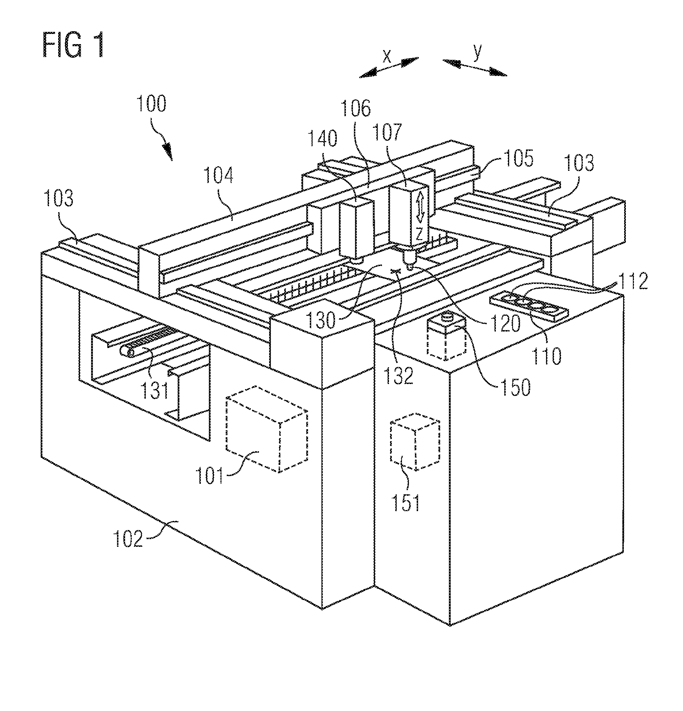

Figur 1 zeigt einen Bestückautomaten 100, welcher einen Rahmen 102 aufweist, an dem zwei parallel ausgerichtete stationäre Linearführungen 103 angebracht sind. Die beiden Führungen 103 tragen einen quer stehenden Trägerarm 104. Der quer stehende Trägerarm 104 weist selbst eine lediglich schematisch dargestellte Linearführung 105 auf, an welcher ein Halteelement 106 verschiebbar gelagert ist. Die beiden Linearführungen 103 verlaufen entlang einer y-Richtung, die Linearführung 105 verläuft entlang einer x-Richtung.

An dem Halteelement 106 ist ein Bestückkopf 107 befestigt, welcher zumindest eine Bauelement-Haltevorrichtung 120 aufweist. Gemäß dem hier dargestellten Ausführungsbeispiel ist die Haltevorrichtung eine Saugpipette 120, die mittels eines nicht dargestellten Antriebs entlang einer zu der x- und zu der y-Richtung senkrechten z-Richtung verschiebbar ist.

Um die Winkellage von aufgenommenen Bauelementen zu korrigieren und um damit die Bauelemente in einer korrekten Orientierung bestücken zu können, ist ferner ein nicht dargestellter Drehantrieb vorgesehen. Mittels des Drehantriebs kann die Saugpipette 120 um ihre Längsachse gedreht werden.

Der Bestückautomat 100 weist ferner eine Bauelement-Zuführeinrichtung 110 auf, über welche in Figur 1 nicht dargestellte Bauelemente dem Bestückprozess an Bauelement-Abholpositionen 112 zugeführt werden können. Ferner umfasst der Bestückautomat 100 ein Förderband 131, mit dem ein Bauelementeträger bzw. eine Leiterplatte 130 in den Bestückbereich eingebracht werden kann. Die Saugpipette 107 kann durch eine entsprechende Bewegung des Bestückkopfes 107 parallel zu der xy-Ebene innerhalb des gesamten Bestückbereichs positioniert werden.

Der Bestückautomat 100 weist außerdem einen Prozessor bzw. eine Datenverarbeitungseinrichtung 101 auf. Auf der Datenverarbeitungseinrichtung 101 kann ein Bearbeitungsprogramm für den Bestückautomaten 100 zum Bestücken von Leiterplatten 130 mit Bauelementen ausgeführt werden, so dass alle Komponenten des Bestückautomaten 100 in synchronisierter Weise arbeiten und somit zu einem fehlerfreien und zügigem Bestücken von Leiterplatten 130 mit Bauelementen beitragen.

An dem Halteelement 106 ist zusätzlich eine sog. Leiterplatten-Kamera 140 befestigt, welche zur Erfassung von zumindest einer an der Leiterplatte 130 angebrachten Markierung 132 vorgesehen ist. Auf diese Weise kann die genaue Position der in dem Bestückbereich eingebrachten Leiterplatte 130 durch eine Lagevermessung der Markierung 132 innerhalb des Gesichtsfeldes der Leiterplatten-Kamera 140 bestimmt werden.

Zur Positionsvermessung und zur Kontrolle von aufgenommenen Bauelementen ist eine Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelemente-Kamera 150. Das von der Kamera 150 aufgenommene Bild wird in einer Auswerteeinheit 151 ausgewertet und dabei die Lage des aufgenommenen Bauelements relativ zu der Saugpipette 120 ermittelt.

Die Auswerteeinheit 151 kann auch in der Datenverarbeitungseinrichtung 101 integriert sein. Dabei kann die Auswerteeinheit 151 mittels einer eigenen Hardware oder auch mittels einer geeigneten Software realisiert sein.

Es wird darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition 112 hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und welcher somit gleichzeitig mehrere Bauelemente transportieren kann. Dabei können die Haltevorrichtungen zeilen- bzw. matrixartig angeordnet sein. Ebenso können die Haltevorrichtungen jedoch auch um eine Rotationsachse radial abstehend abgeordnet sein, so dass durch eine Drehung der Haltevorrichtungen mehrere Bauelemente sequentiell aufgenommen und auch wieder abgesetzt werden können. Selbstverständlich kann die Erfindung auch mit beliebigen anderen Arten von Einfach- oder Mehrfach-Bestückköpfen realisiert werden.

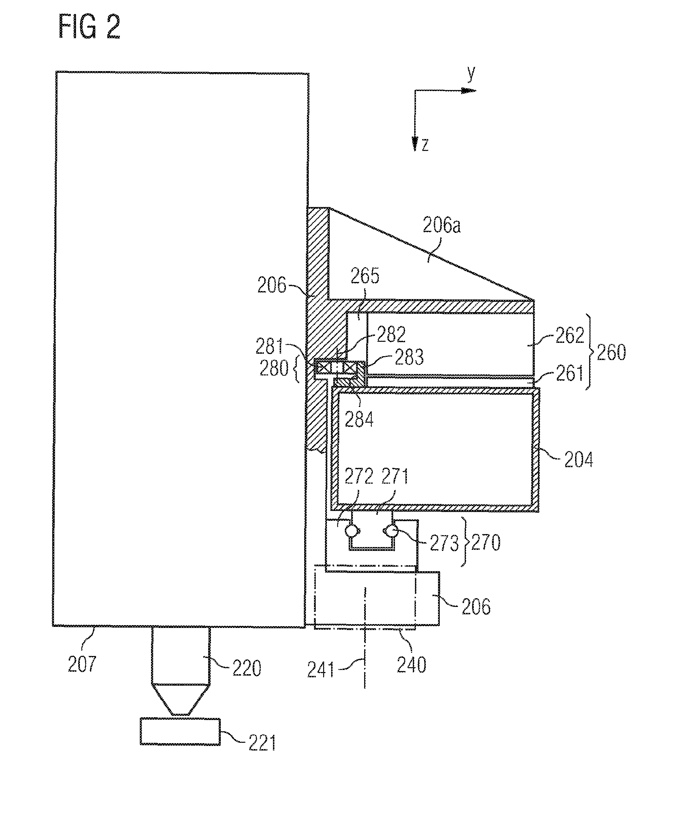

Figur 2 zeigt eine Querschnittsansicht eines linearen Positioniersystems, bei dem ein Halteelement 206 an einem Trägerarm 204 entlang einer zu der y-Achse und zu der z-Achse senkrechten x-Achse (d.h. senkrecht zur Zeichenebene) verschiebbar gelagert ist. An dem Halteelement 206 ist ein Bestückkopf befestigt. Das Halteelement 206 weist eine weitgehend plane Fläche auf, die eine stabile Befestigung des Bestückkopfes beispielsweise mittels einer Schraubverbindung erlaubt. Das Halteelement wird deshalb auch als Kopfhalteplatte 206 bezeichnet.

Der Bestückkopf 207 weist eine als Saugpipette ausgebildete Haltevorrichtung 220 auf. Die Haltevorrichtung 220 kann bei Anlegen eines entsprechenden Unterdrucks in bekannter Weise ein elektronisches Bauelement 221 aufnehmen.

An dem Halteelement 206 ist ferner eine sog. Leiterplattenkamera 240 angeordnet, welche entlang einer optischen Achse 241 Markierungen einer nicht dargestellten Leiterplatte erfassen kann. Mittels einer der Kamera 240 nachgeschalteten Auswerteeinheit kann somit anhand der erfassten Markierungspositionen die exakte räumliche Lage der zu bestückenden Leiterplatte ermittelt werden. Die Befestigung der Kamera 240 an dem Halteelement 206 hat den Vorteil, dass zum Positionieren der Kamera 240 ein separates Kamera-Positioniersystem nicht bereitgestellt werden muss.

Die Verschiebung des Halteelements 206 erfolgt mittels eines Linearmotors 260. Der Linearmotor weist einen mit dem Trägerarm 204 gekoppelten Stator 261 und einen mit dem Halteelement 206 gekoppelten Läufer 262 auf. Der Stator 261 ist mittels einer Magnetleiste realisiert, bei der senkrecht zur Zeichenebene mehrere Permanentmagnete mit abwechselnder Polarität hintereinander angeordnet sind. Der Läufer 262 weist eine Magnetspuleneinheit auf, welche durch nicht dargestellte elektrische Versorgungsleitungen mit Strom beaufschlagt werden kann.

Wie aus Figur 2 ersichtlich, ist die Magnetspuleneinheit 262 entlang der y-Achse derart von dem Halteelement 206 beabstandet, dass zwischen Magnetspuleneinheit 262 und Halteelement 206 ein Zwischenraum 265 gebildet ist. Dieser Zwischenraum trägt zu einer weit reichenden thermischen Entkopplung zwischen dem Linearmotor 260 und dem Halteelement 206 bei. In diesem Zusammenhang ist zu beachten, dass infolge des elektrisch passiven Stators 261 lediglich der elektrisch aktive Läufer 262 einen signifikanten Beitrag zu der Wärmeentwicklung des Linearmotors 260 liefert.

Durch die beschriebene Beabstandung zwischen Halteelement 206 und Läufer 262 ist somit auch die indirekt über das Halteelement 206 auf den Bestückkopf 207 transferierte Wärme deutlich reduziert. Damit kann der Bestückkopf 207 auch bei einem hochdynamischen Betrieb des Positioniersystems unter thermisch weitgehend stabilen Bedingungen betrieben werden. Somit führt die beschriebene thermische Entkopplung nicht nur zu einer verbesserten Positioniergenauigkeit, sondern auch zu einer präziseren Bestückung durch den von thermischen Verzügen weitgehend befreiten Bestückkopf 207.

Wie ferner aus Figur 2 ersichtlich, ist das Lagerungssystem des dargestellten Positioniersystems bzw. der x-Achse eines Flächenpositioniersystems aus einer Kombination von zwei Lagerungen, einem ersten Lager 270 und einem zweiten Lager 280, aufgebaut.

Die untere Lagerung 270 besteht gemäß dem hier dargestellten Ausführungsbeispiel aus zwei entlang der x-Achse versetzten Führungswägen 270, von denen in der dargestellten Querschnittsansicht lediglich ein Führungswagen 270 zu erkennen ist. Selbstverständlich können auch mehr als zwei Führungswägen 270 verwendet werden.

Die Führungswägen 270 sind mittels eines Kugellagers 273 an einer an dem Trägerarm 204 befestigten Führungsschiene 271 verschiebbar befestigt. Die Führungswägen 270 und die Führungsschiene 271 wirken dabei derart zusammen, dass die erste bzw. die untere Lagerung 270 quer zur x-Achse ein Festlager und entlang der x-Achse ein Loslager darstellt. Damit stellt die erste Lagerung 271 bereits eine vollständig funktionsfähige Linearführung dar, die jedoch infolge der magnetischen Anziehungskraft zwischen Läufer 262 und Stator 261 einem Kippmoment des Halteelements 206 in Uhrzeigerrichtung ausgesetzt ist.

Es wird darauf hingewiesen, dass die untere Lagerung 270 zusammen mit der Steifigkeit des Halteelements 206 so ausgelegt sein kann, dass dieses durch die Magnetkraft zwischen Läufer 262 und Stator 261 erzeugte Kippmoment von der Lagerung 270 aufgenommen wird. Die Steifigkeit des Halteelements 206 kann durch die Dimensionierung eines Versteifungselements 206a an die jeweiligen Anforderungen angepasst werden.

Die zweite Lagerung 280 weist zumindest eine Rolle 281 auf, die in einer Drehachse 282 drehbar gelagert ist. Die Drehachse befindet sich relativ zu dem Halteelement 206 in einer festen räumlichen Position, so dass bei einer Verschiebung des Haltelements 206 entlang der x-Achse die Rolle 281 an einer Lauffläche 284 eines Profilelements 283 abrollt. Das Profilelement 283 ist fest mit dem Trägerarm 204 verbunden. Durch eine Justierung der Position des Profilelements 283 an dem Trägerarm 204 kann die Größe des Magnetspaltes zwischen Stator 261 und Läufer 262 und eingestellt werden. Alternativ kann die Lauffläche jedoch auch direkt an dem Trägerarm 204 ausgebildet sein.

Durch die Magnetkraft zwischen Stator 261 und Läufer 262 wird ein Kippmoment des Halteelements 206 erzeugt, welches dazu führt, dass die Laufrolle 281 gegen die Lauffläche 284 gedrückt wird. Damit wird die räumliche Lage des Halteelements 206 auch bei hochdynamischen Bewegungen des Bestückkopfes 207 genau festgelegt, so dass unabhängig von dem Bewegungszustand des Bestückkopfes 207 stets eine hohe Positioniergenauigkeit und damit auch eine hohe Bestückgenauigkeit gewährleistet werden kann.

Das dargestellte Positioniersystem ist so ausgelegt, dass die Rolle 281 im wesentlichen lediglich der Aufnahme von dynamischen Lasten dient. Dies bedeutet, dass die Rolle 281 nicht mit dem gesamten durch die Magnetkraft des Linearmotors 260 verursachten Kippmoment beaufschlagt wird. Dieses Kippmoment wird nämlich zum größten Teil von der ersten Lagerung 270 aufgenommen. Die Vorspannung der Rolle 281 kann beispielsweise durch die mechanische Steifigkeit des Halteelements 206 bzw. durch die Verformung des Halteelements 206 infolge der Magnetkraft des Linearmotors 260 eingestellt werden.

Es wird darauf hingewiesen, dass der Linearmotor 260 auch in einer anderen Orientierung an dem Trägerarm 204 bzw. an dem Halteelement 206 befestigt sein kann. So kann der Magnetspalt des Linearmotors 260 in einem beliebigen Winkel zwischen 0° und 90° relativ zu der xy-Ebene orientiert sein. Durch eine geeignete Wahl dieses Winkels, d.h. durch eine geeignete Schrägstellung des Linearmotors 260 kann die durch die Magnetkraft verursachte Andrückkraft der Laufrolle 281 auf die Lauffläche 284 eingestellt werden. Dabei ist diese Andrückkraft dann maximal, wenn der Magnetspalt parallel zu der xz-Ebene orientiert ist. Anders ausgedrückt ist die Andrückkraft dann maximal, wenn der oben definierte Winkel 90° beträgt.

Es wird ferner darauf hingewiesen, dass der Linearmotor auch auf der Rückseite, d.h. links von dem in Figur 2 dargestellten Trägerarm 204 angeordnet werden kann.

Das beschriebene Konzept eines linearen Positioniersystems insbesondere für einen Bestückautomaten hat den Vorteil, dass das gesamte lineare Lagerungssystem zusammen mit dem Linearmotor innerhalb einer kompakten und bauraumtechnisch günstigen Bauweise realisiert werden kann. Ferner verhindert die Lager- und Rollenanordnung eine Verspannung des Systems infolge von Wärme, so dass keine thermisch bedingten hohen Lagerlasten auftreten können. Das beschriebene Lagerungsprinzip ermöglicht in Folge der einfachen mechanischen Komponenten eine sehr kostengünstige Realisierung der x-Achse für einen Bestückautomaten.

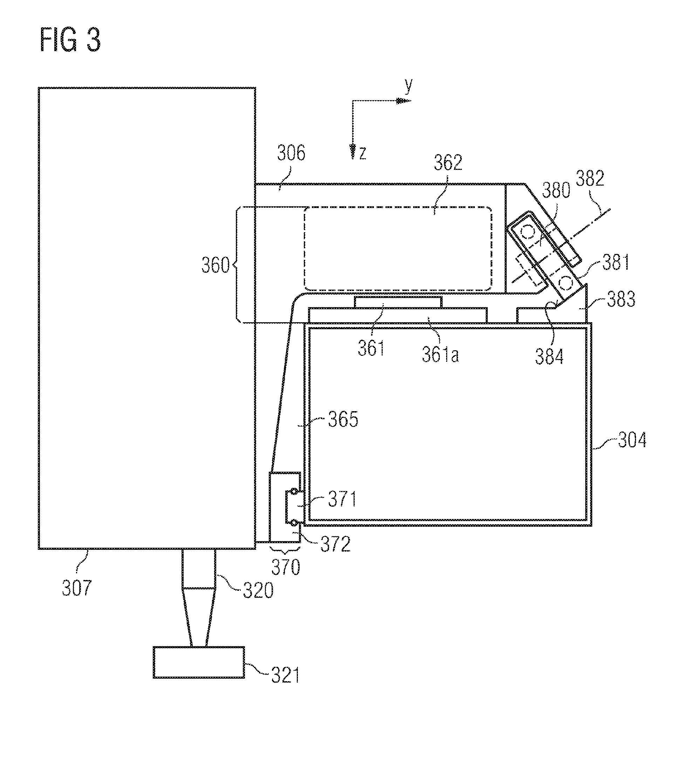

Figur 3 zeigt eine Querschnittsansicht eines linearen Positioniersystems gemäß einem zweiten Ausführungsbeispiel der Erfindung. Im Gegensatz zu der mit Figur 2 beschriebenen Ausführungsform liegt die zweite Lagerung 380 nicht an einem dem Bestückkopf 307 zugewandten Abschnitt des Halteelements 306, sondern an einer dem Bestückkopf 307 abgewandten Abschnitt des Halteelements 306 an. Dies bedeutet, dass in Bezug auf den Trägerarm 304 die Auflagefläche der zweiten Lagerung 380, welche ein Loslager darstellt, auf die räumliche Anordnung der ersten Lagerung 370, welche ein Festlager darstellt, ausgerichtet ist.

Die Rolle 381 der zweiten Lagerung 380 ist um die Drehachse 382 drehbar gelagert. Die Rolle 381 liegt an einer Lauffläche 384 eines Profilelements 383 an. Die Lauffläche ist beispielsweise ein gehärtetes Blech, welches einen geringen Abrieb aufweist. Die Lauffläche 384 ist in Bezug auf die y- und die z-Richtung schräg ausgerichtet, so dass bei einer magnetischen Anziehungskraft zwischen dem Läufer 362 des Linearmotors 360 und dem Stator bzw. der Magnetleiste 361 des Linearmotors 360 die Laufrolle 381 senkrecht gegen die Lauffläche 384 gedrückt wird.

Die einzelnen vorzugsweise Permanentmagneten der Magnetleiste 361 sind an einer Rückschlussplatte 361a angebracht. Zwischen dem Halteelement 306 und dem Trägerarm 304 ist ein Zwischenraum 365 vorhanden, der zu einer zusätzlichen thermischen Entkopplung zwischen dem Bestückkopf 307 und dem Linearmotor 360 beiträgt.

Die erste Lagerung 370, welche eine Führungsschiene 371 und einen Führungswagen 372 aufweist, stellt in Bezug auf die yz-Ebene ein Festlager 370 dar. Bei einer magnetischen Anziehung zwischen dem Läufer 362 und dem Stator 361 wird somit ein Drehmoment erzeugt, wobei das Festlager 370 den virtuellen Drehpunkt darstellt. Der virtuelle Hebelarm dieses Drehmoments verläuft somit in schräger Richtung quer durch den Trägerarm 304.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

Bezugszeichenliste
- 100: Bestückautomat
- 101: Datenverarbeitungseinrichtung / Prozessor
- 102: Rahmen
- 103: stationäre Linearführungen
- 104: quer stehender Trägerarm
- 105: Linearführung
- 106: Halteelement
- 107: Bestückkopf
- 110: Bauelement-Zuführeinrichtung
- 112: Bauelement-Abholpositionen
- 120: Haltevorrichtung / Sauggreifer / Saugpipette
- 130: Bauelementeträger / Leiterplatte / Referenzebene
- 131: Förderband
- 132: Markierung
- 140: Leiterplatten-Kamera
- 150: Bauelemente-Kamera
- 151: Auswerteeinheit

- 204: Trägerarm
- 206: Halteelement / Kopfhalteplatte
- 206a: Versteifungselement
- 207: Bestückkopf
- 220: Haltevorrichtung / Saugpipette
- 221: Bauelement
- 240: Leiterplatten-Kamera
- 241: optische Achse
- 260: Linearmotor
- 261: Stator / Magnetleiste
- 262: Läufer / Magnetspuleneinheit
- 265: Zwischenraum
- 270: erste Lagerung
- 271: Führungsschiene
- 272: Führungswagen / Schlitten
- 273: Kugellager
- 280: zweite Lagerung
- 281: Rolle
- 282: Drehachse
- 283: Profilelement
- 284: Lauffläche

- 304: Trägerarm
- 306: Halteelement / Kopfhalteplatte
- 307: Bestückkopf
- 320: Haltevorrichtung / Saugpipette
- 321: Bauelement
- 360: Linearmotor
- 361: Stator / Magnetleiste
- 361a: Rückschlussplatte
- 362: Läufer / Magnetspuleneinheit
- 365: Zwischenraum
- 370: erste Lagerung
- 371: Führungsschiene
- 372: Führungswagen / Schlitten
- 380: zweite Lagerung / Loslager
- 381: Rolle
- 382: Drehachse
- 383: Profilelement
- 384: Lauffläche

## Patentansprüche

1. Positioniersystem zum Bewegen eines Bestückkopfes (107, 207, 307) eines Bestückautomaten (100) entlang einer x-Achse zum Zwecke der Bestückung von Bauelementeträgern (130) mit elektronischen Bauelementen (221, 321), das Positioniersystem aufweisend
• einen Trägerarm (104, 204, 304),
• eine Linearführung (105),
welche an dem Trägerarm (104, 204, 304) angebracht ist und
welche entlang einer x-Achse verläuft,
• ein Halteelement (106, 206, 306),
welches an der Linearführung (105) entlang der x-Achse verschiebbar gelagert ist und
welches derart ausgebildet ist, dass der Bestückkopf (107, 207, 307) an dem Halteelement (106, 206, 306) anbringbar ist, und
• einen Linearmotor (260, 360), welcher mit dem Trägerarm (104, 204, 304) und dem Halteelement (106, 206, 306) derart gekoppelt ist, dass bei einer entsprechenden Ansteuerung des Linearmotors (260, 360) das Halteelement (106, 206, 306) entlang der x-Achse verfahrbar ist,
wobei
- zumindest ein Abschnitt des Halteelements (106, 206, 306), an welchem Abschnitt der Bestückkopf (107, 207, 307) anbringbar ist, relativ zu dem Trägerarm (104, 204, 304) auf einer ersten Seite angeordnet ist und
- der Linearmotor (260, 360) relativ zu dem Trägerarm (104, 204, 304) auf einer zweiten Seite angeordnet ist, die unterschiedlich zu der ersten Seite ist.

2. Positioniersystem nach Anspruch 1, bei dem
der Linearmotor (260) zumindest entlang einer zu der x-Achse senkrechten y-Achse von dem Halteelement (106, 206) beabstandet ist, so dass zwischen Halteelement (106, 206) und Linearmotor (260) ein erster Zwischenraum (265) vorhanden ist.

3. Positioniersystem nach Anspruch 2, bei dem
der Trägerarm (104, 204) entlang der y-Achse von dem Halteelement (106, 206) beabstandet ist, so dass zwischen Halteelement (106, 206) und Trägerarm (104, 204) ein zweiter Zwischenraum vorhanden ist.

4. Positioniersystem nach einem der Ansprüche 1 bis 3, bei dem
der Linearmotor (260, 360) aufweist
• einen Stator (261, 361), welcher an dem Trägerarm (104, 204, 304) angebracht ist, und
• einen Läufer (262, 362), welcher an dem Halteelement (106, 206, 306) angebracht ist.

5. Positioniersystem nach Anspruch 4, bei dem
die Linearführung eine erste Lagerung (270, 370) aufweist, die eine Führungsschiene (271, 371) und zumindest einen Linearführungswagen (272, 372) umfasst, welcher derart an der Führungsschiene (271, 371) angebracht ist, dass die erste Lagerung (270, 370) quer zur x-Achse ein Festlager und parallel zur x-Achse ein Loslager darstellt.

6. Positioniersystem nach Anspruch 5, bei dem
die Linearführung eine zweite Lagerung (280, 380) aufweist, die ein Loslager darstellt und die in Bezug auf die erste Lagerung (270, 370) derart angeordnet ist, dass
eine zwischen Stator (261, 361) und Läufer (262, 362) erzeugt magnetische Anziehungskraft des Linearmotors (260) eine Fixierung des Loslagers (280, 380) zumindest entlang der y-Achse bewirkt.

7. Positioniersystem nach Anspruch 6, bei dem
die zweite Lagerung (280, 380) zumindest eine Rolle (281, 381) aufweist, welche an einer Abrollfläche (284, 384) des Trägerarms (204, 304) oder des Halteelements abrollbar ist.

8. Positioniersystem nach einem der Ansprüche 6 bis 7, bei dem
die erste Lagerung (270, 370) unterhalb der zweiten Lagerung (280, 380) angeordnet ist.

9. Positioniersystem nach einem der Ansprüche 1 bis 8, bei dem
das Halteelement eine Kopfhalteplatte ist (106, 206, 306).

10. Flächen-Positioniersystem zum Bewegen eines Bestückkopfes (107, 207, 307) eines Bestückautomaten (100) parallel zu einer durch eine x-Achse und eine y-Achse definierten Bestückebene zum Zwecke der Bestückung von Bauelementeträgern (130) mit elektronischen Bauelementen (221, 321), das Flächen-Positioniersystem aufweisend
• eine stationäre Linearführung (103), welche entlang einer y-Richtung verläuft, und
• ein Positioniersystem nach einem der Ansprüche 1 bis 9.

11. Vorrichtung zum automatischen Bestücken von Bauelementeträgern (130) mit elektronischen Bauelementen (221, 321), die Vorrichtung aufweisend:
• ein Positioniersystem nach einem der Ansprüche 1 bis 9 und/oder ein Flächen-Positioniersystem nach Anspruch 10.

12. Vorrichtung nach Anspruch 11, zusätzlich aufweisend
eine Bauelement-Zuführvorrichtung (110) zum sequentiellen Bereitstellen von Bauelementen (221, 321) an zumindest einer Abholposition (112), von der die Bauelemente (221, 321) von dem Bestückkopf (107, 207, 307) aufgenommen werden können.

13. Vorrichtung nach einem der Ansprüche 11 bis 12, zusätzlich aufweisend
eine Kamera (140, 240),
welche relativ zu dem Halteelement (106, 206) in einer festen räumlichen Position angeordnet ist und
welche zur Erfassung eines in einen Bestückbereich eingebrachten Bauelementeträgers (130) eingerichtet ist.
